# EUROPÄISCHE PATENTANMELDUNG

(11) **EP 2 620 977 A2**
(43) Veröffentlichungstag der Anmeldung: **31.07.2013**
(21) Anmeldenummer: 13152044.7
(22) Anmeldetag: 21.01.2013
(51) Int. Cl.: H01L 21/68

(54) **Hybridkinematik mit sechs Freiheitsgraden**

(30) Priorität: 20.01.2012 DE 102012000989
(71) Anmelder: SmarAct Holding GmbH, 26135 Oldenburg (DE)
(72) Erfinder: Raß, Christoph, 26131 Oldenburg (DE); Kortschack, Axel, 26121 Oldenburg (DE)
(74) Vertreter: Eisenführ, Speiser & Partner

(57) **Zusammenfassung**

Die Erfindung betrifft eine Vorrichtung zur Bewegung eines Objektes in sechs Freiheitsgraden in Form einer hybriden Parallelkinematik die über lineare Antriebe bewegt wird.

Erfindungsgemäß nutzen drei lineare Antriebe auf der Ebene der stationären Basis eine gemeinsame Führungsschiene auf der diese verfahren können.

## Beschreibung

Es sind Parallelkinematiken und hybride Parallelkinematiken bekannt, die in der Lage sind ein Objekt im Raum zu positionieren.
Parallelkinematiken unterscheiden sich von den klassischen, seriellen Kinematiken, bei denen die Bewegungsachsen hintereinander, also seriell angeordnet sind, insofern, dass bei Parallelkinematiken die kinematischen Ketten funktionell parallel angeordnet sind.
Im Falle hybrider Parallelkinematiken liegt eine Mischung aus einer seriellen und einer Parallelkinematik vor. Dass heißt, dass mindestens eine geschlossene kinematische Kette der hybriden Parallelkinematik mit mehr als einem Freiheitsgrad bewegt werden kann, während diese Freiheitsgerade durch mindestens zwei in Serie befindliche Aktoren erzeugt werden.

Eine beispielhafte hybride Parallelkinematik besteht aus drei XY-Tischen, die im Zusammenspiel ein Objekt in allen sechs Freiheitsgraden bewegen können.

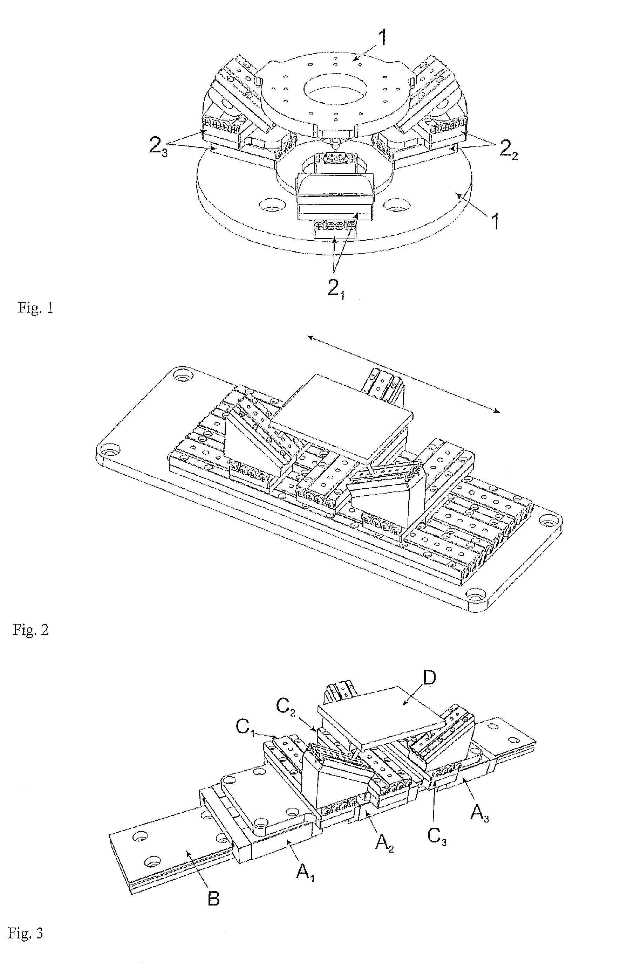

In Fig. 1 ist eine aus dem Stand der Technik bekannte hybride Parallelkinematik dargestellt.
Zu erkennen sind drei XY-Tische, die so angeordnet sind, dass die jeweils unteren Antriebe auf eine gemeinsames Zentrum ausgerichtet sind, während die jeweils oberen Antrieb des XY-Tisches eine tangentiale Bewegung um einen gemeinsamen virtuellen Kreis aufweisen.
Sollen in einer oder mehreren linearen Richtungen große Vierfahrwege durchgeführt werden, so lässt sich die Konstruktion anpassen.

Fig. 2. zeigt eine beispielhaft modifizierte Konstruktion, bei der die XY-Tische so gedreht sind, dass die jeweils unteren Antrieb der drei XY-Tische in eine gemeinsame Richtung fahren können und die jeweils oberen Antriebe der drei XY-Tische in eine dazu um 90° gedrehte Richtung fahren können. Werden nun, wie z.B. in der Fig. 2 dargestellt die Verfahrwege entsprechend lang gewählt, so kann die hybride Parallelkinematik das zu bewegende Objekt entsprechend weit entlang der gewählten Verfahrwege bewegen.

Ein solcher Aufbau erlaubt zwar große Positionerstrecken in eine Richtung, jedoch ist der Aufbau verhältnismäßig kompliziert. Es hat sich gezeigt, dass es beim Aufbau einer solchen hybriden Parallelkinematik sehr akribischer und damit kostenintensiver Ausrichtarbeiten bedarf. Das hat besonders für Präzisionspositionieraufgaben, wie z.B. die Nanopositionierung hohe Relevanz.

Aus dem Vorgenannten ist es daher Aufgabe der Erfindung, eine Vorrichtung zu schaffen, bei der die notwendigen Ausrichtarbeiten gering gehalten werden, so dass kostengünstig qualitativ hochwertige hybride Parallelkinematiken aufgebaut werden können.

Die Lösung der Aufgabe der Erfindung erfolgt durch die Lehre gemäß Definition nach Patentanspruch 1, wobei die Unteransprüche mindestens zweckmäßige Ausgestaltungen und Weiterbildungen darstellen.

Demnach wird erfindungsgemäß bei der hybriden Parallelkinematik eine gemeinsame Führungsschiene für drei Antriebe verwendet. Diese drei Antriebe können auf der Führungsschiene unabhängig voneinander bewegt werden. Auf den Antrieben befinden sich je ein weiterer linearer Antrieb. Diese weiteren Antriebe können ebenfalls unabhängig voneinander bewegt werden.

Somit bilden sich drei XY-Tische, die in einer Richtung eine gemeinsame Führungsschiene aufweisen.

Die drei XY-Tische werden mit einem zu positionierenden Objekt beweglich verbunden, so dass dieses Objekt in sechs Freiheitsgraden bewegt werden kann. Durch die Verwendung einer gemeinsamen Führungsschiene für die untere Richtung der drei XY-Tische entfällt die bisher übliche, kostenintensive Ausrichtarbeit. Da Führungsschienen bekanntermaßen sehr präzise geschliffen werden können, ergibt sich somit eine sehr hohe Parallelität der Bewegung entlang dieser Führungsschiene.

Die Präzision der sich so ergebenden hybriden Parallelkinematiken hängt ganz wesentlich von den gewählten Lagern, Gelenken und den Antrieben ab. Es hat sich herausgestellt, dass piezobasierte Antriebe aufgrund ihrer hohen Steifigkeit und feinen Bewegungsauflösung besonders gut in der Lage sind hybride Parallelkinematik anzutreiben, sodass diese für Nanoapplikationen geeignet sind.

Antriebe mit einer hohen Steifigkeit, wie z.B. piezobasierte Antriebe, erlauben es neben Wälzlagern auch Gleitlager einzusetzen und trotzdem eine Bewegungsauflösung im Sub-Nanometerbereich zu erzielen.

Eine besonders hohe Positioniergenauigkeit lässt sich erzielen, wenn die Achsbewegungen durch Sensoren, z.B. optische Encoder, überwacht werden.

Dabei kann die gemeinsam genutzte Führungsschiene mit einem Maßstab ausgestattet werden, der von den drei, auf der Führungsschiene beweglichen Antrieben gemeinsam genutzt wird. Das reduziert Ungenauigkeiten aufgrund von Ausrichtfehlen der Maßstäbe.

Die Erfindung soll nachstehen anhand eines Ausführungsbeispiels sowie unter Zuhilfenahme von Figuren nähre erläutert werden.

Hierbei zeigen:
Fig. 1: Prinzipskizze einer bekannten hybriden Parallelkinematik;
Fig. 2: Prinzipskizze einer bekannten hybriden Parallelkinematik mit einem großen Hub in einer linearen Richtung;
Fig. 3: Prinzipskizze einer erfindungsgemäßen, hybriden Parallelkinematik mit einem großen Hub in eine linearen Richtung.

Fig. 1 zeigt eine vereinfachte Darstellung einer bekannten hybriden Parallelkinematik. Dargestellt sind sie typischen Komponenten. Dabei handelt es sich um einen Basis (1), auf der drei XY-Tische (2₁, 2₂, 2₃) befestigt sind. Diese drei XY-Tische übertragen die Bewegung über ein Lagerkonstrukt, bestehend aus Linearführungen und Gleitlagern, auf eine zu bewegende Plattform (3).

Fig. 2 zeigt eine ähnliche hybride Parallelkinernaiik wie Fig. 1. Jedoch sind die drei XY-Tische in diesem Fall so gedreht, dass die Bewegungsrichtungen im geometrische Sinne parallel verlaufen. Das ermöglichst es bei einer kompakten Bauform entlang der Achsrichtungen der XY-Tische große Positionierstrecken zu verfahren. Je länger die Führungen gewählt werden, desto länger ist die mögliche Positionerstrecke. In Richtung des dargestellten Doppelpfeils hat die dargestellte Parallelkinematik einen besonders großen linearen Hub.

Fig. 3 zeigt eine beispielhafte Ausführung einer erfindungsgemäßen hybriden Parallelkinematik. Es befinden sich drei Antriebe (A₁, A₂, A₃) auf einer gemeinsamen Führungsschiene (B). Auf den drei vorgenannten Antrieben befindet sich in Serie jeweils ein weiterer linearer Antrieb (C₁, C₂, C₃), so dass sich drei XY-Tische bilden. Diese drei XY-Tische mit einer gemeinsamen Führungsschiene in den jeweils unteren Antrieben übertragen die Bewegung über ein Lagerkonstrukt, bestehend aus Linearführungen und Gleitlagern, auf eine zu bewegende Plattform (D).

## Patentansprüche

1. Vorrichtung zur Bewegung eines Objektes in sechs Freiheitsgraden mit einer hybriden Parallelkinematik die über lineare Antriebe bewegt wird,
**dadurch gekennzeichnet, dass**
drei lineare Antriebe auf der Seite der stationären Basis auf einer gemeinsamen Führungsschiene verfahren können.

2. Vorrichtung nach Anspruch 1,
**dadurch gekennzeichnet, dass**
es sich bei den Antrieben um Piezoantriebe handelt.

3. Vorrichtung nach einem der vorhergehenden Ansprüche,
**dadurch gekennzeichnet, dass**
die Position und Bewegung der Antriebe durch Sensoren überwacht werden.

4. Vorrichtung nach einem der vorhergehenden Ansprüche,
**dadurch gekennzeichnet, dass**
die Sensoren der Antriebe die auf der gemeinsamen Führungsschiene fahren einen gemeinsamen Maßstab nutzen.
